# EUROPEAN PATENT SPECIFICATION

(11) **EP 0 655 831 B1**
(45) Date of publication and mention of the grant of the patent: **28.07.1999**
(21) Application number: 93830479.7
(22) Date of filing: 30.11.1993
(51) Int. Cl.: H03F 3/45, H03F 1/08

(54) **High performance transconductance operational amplifier, of the CMOS integrated type**
CMOS-integrierter Hochleistungs-Transkonduktanz-Operationsverstärker
Amplificateur opérationnel de transconductance à haute performance intégrée à CMO

(43) Date of publication of application: 31.05.1995
(73) Proprietor: STMicroelectronics S.r.l., 20041 Agrate Brianza (Milano) (IT)
(72) Inventor: Pernici, Sergio, I-24121 Bergamo (IT)
(74) Representative: Botti, Mario

(56) References cited:
- US-A- 5 079 514
- PATENT ABSTRACTS OF JAPAN vol. 6, no. 136 (E-120) (1014) 23 July 1982 & JP-A-57 060 711 (SUWO SEIKOSHA K.K.) 12 April 1982
- PATENT ABSTRACTS OF JAPAN vol. 10, no. 279 (E-439) (2335) 20 September 1986 & JP-A-61 100 010 (SONY CORP.) 19 May 1986
- PATENT ABSTRACTS OF JAPAN vol. 8, no. 139 (E-253) 28 June 1984 & JP-A-59 050 556 (NIPPON DENSHIN DENWA KOSHA) 23 March 1984
- IEEE JOURNAL OF SOLID-STATE CIRCUITS., vol.25, no.4, August 1990, NEW YORK US pages 987 - 995, XP000149248 D. SENDEROWICZ ET AL 'PCM TELEPHONY: REDUCED ARCHITECTURE FOR A D/C CONVERTER AND FILTER COMBINATION'

## Description

The present invention relates to transconductance amplifiers and in particular a differential transconductance amplifier monolithically integrable with CMOS technology.

By using CMOS processes at present it is possible to provided in a single integrated circuit complex systems comprising both analog and digital parts.

For the analog parts provision of valid operational transconductance amplifiers (OTA) is essential.

Indeed, these amplifiers are the basis for the provision of many complex circuits such as filters or other circuits with switched, coding, decoding, etc. condensers as disclosed in the article of Senderowick et al. "PCM Telephony: Reduced Architecture for a D/C Converter ad Filter Combination" - IEEE Journal of Solid-State Circuit - August 1990, regarding to a more robust and cost-efficient PCM telephone system. These amplifiers fall in the broader class of operational amplifiers but are characterised by rather high output impedance even with closed loop. For this reason these amplifiers are particularly well suited in structures with feedback and capacitive load such as for example the above mentioned switched condenser circuits. But for resistive feedback, because of the high output impedance even higher feedback resistors should be used and hence their use is not always possible.

For some time there has been a considerable ongoing effort to improve the performance of these amplifiers. On one hand it is sought to improve their gain-band product, output dynamics, supply disturbance rejection, noise and output piloting. On the other hand it is sought to reduce supply voltage to make them equivalent to those of digital circuits which, ever more often, operate typically at 3.3V with minima of even 2.7V for battery supply.

The first solutions used by those skilled in the art were rather simple structures but did not offer high performance, especially in terms of stability.

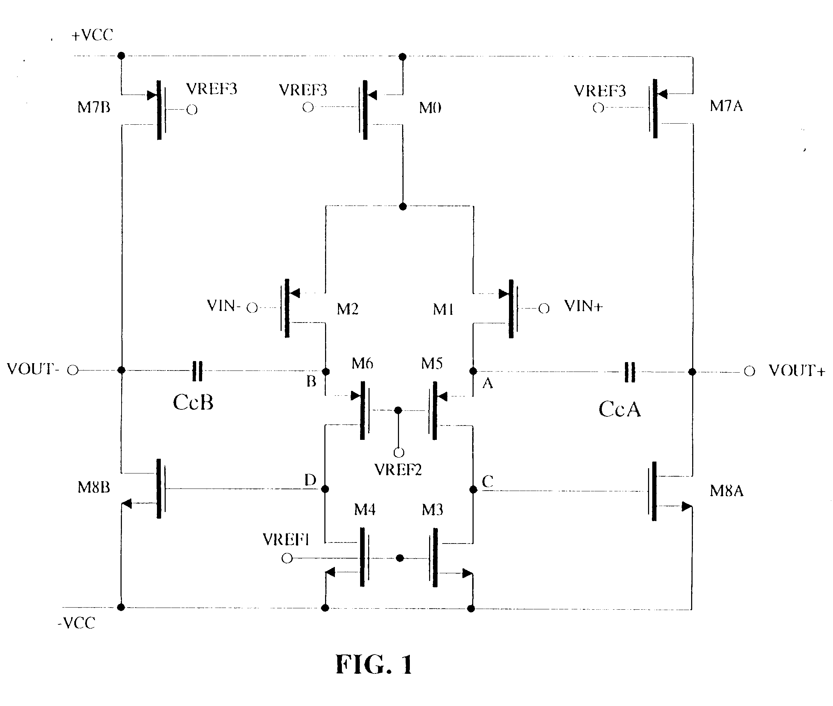

To obviate possible shortcomings the structure represented in FIG. 1 ("Design techniques for cascode CMOS op amp with improved PSRR and common mode input range", Ribner - Copeland JSSC 12/84). This OTA consists of a first cascoded stage and a second gain stage. A compensation capacitance, instead of being connected as in older solutions between the OTA output and the first stage output, is connected to the source terminal of an M5 transistor with grounded gate terminal acting as the cascode. This simple variation considerably improved the circuit. In this manner a zero to the right resulting from the frequency analysis is taken to a slightly higher frequency (as shown in the above mentioned article) and hence degradation of the phase margin introduced by it is less. There is also another zero to the left which further helps improve amplifier stability.

Compared with previous transconductance amplifiers a predominant pole remains unchanged but instead of a second pole there is a doublet of conjugate complex poles shifted to a slightly higher frequency. The shift factor is CC/C1 where CC is the compensation capacitance and C1 is the parasite capacitance at the first stage output.

An example of operational amplifier provided with an improved frequency compensation circuit and method for stabilizing the amplifier is disclosed in the US-A-5 079 514 to Mijuskovic et al..

The technical problem at the base of the invention is to obtain an operational transconductance amplifier (OTA) integrable with CMOS technology which could operate at low power supply voltages (at least down to 2.7V) with high output dynamics and high rejection of disturbances on the supply line and especially having for a given capacitive load characteristics of stability and band-gain product better than those achievable with the solutions of the known art.

This problem is solved by an operational transconductance amplifier of the above mentioned type and defined by the characterising part of the claims which follow this description.

The characteristics and advantages of an operational transconductance amplifier in accordance with the present invention are set forth in the description given below of an embodiment thereof given by way of nonlimiting example with reference to the annexed drawings.

In the drawings -
- FIG. 1 shows the circuitry diagram of the known operational transconductance amplifier mentioned above, and
- FIG. 2 shows a circuitry diagram of an operational transconductance amplifier in accordance with the present invention.

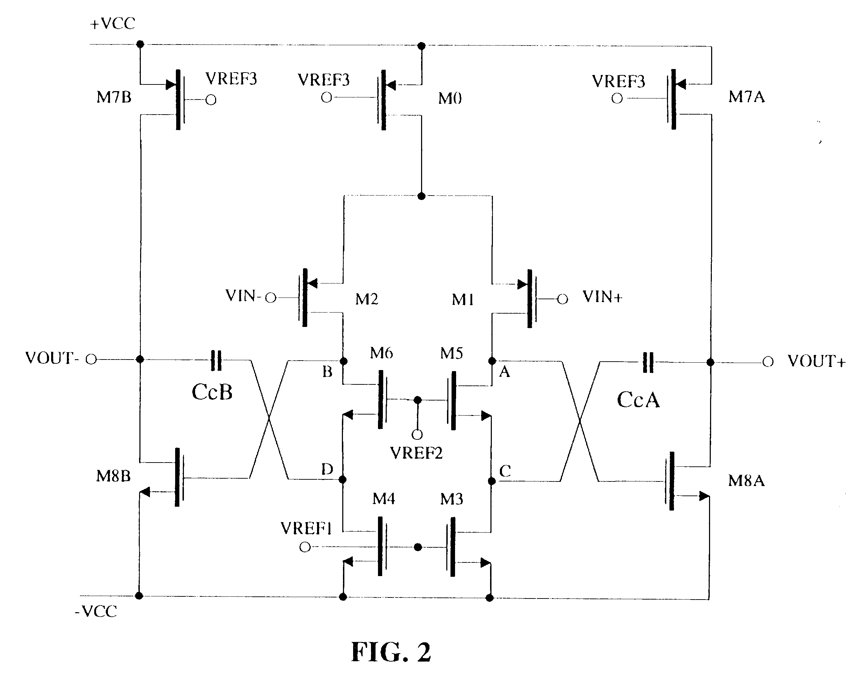

The circuitry diagram shown in FIG. 2 is differential.

In reality even an undifferentiated simplified structure could operate but without the advantages which are the purpose of the present invention.

The circuitry diagram of an operational transconductance amplifier in accordance with the present invention comprises a differential input stage consisting of two transistors M1 and M2 and a pair of cascode stages consisting of two transistors M3 and M5 and two transistors M4 and M6 respectively inserted in series with a current generator consisting of a transistor MO between two terminalS +VCC and -VCC of a supply voltage generator.

In these terminals are inserted two branches of a differential output stage comprising two output transistors M8A and M8B in series with two current generators consisting of two transistors M7A and M7B.

The transistors M1, M2, M7A and M7B are PMOS while all the others are NMOS.

As mentioned above a circuit structure in accordance with the present invention is also the perfectly dual one of the structure given in FIG. 2.

This one is also very well suited to operating at low supply voltages thanks to the high output dynamics.

In accordance with the present invention, in both types of structure the command terminals of the output transistors M8A and M8B are connected to nodes A and B for connection between the input stage and the cascode stages.

The output terminals VOUT+ and VOUT- are connected to intermediate nodes C and D of the cascode stages through condensers CCA and CCB respectively.

A transconductance amplifier in accordance with the present invention offers the same characteristics as the known art shown in FIG. 1 in terms of output dynamics and rejection of disturbances on the supply but compared to it has a large advantage in terms of stability which can be understood by analysing the position of the poles and zeroes of the transfer function between input and output. A circuit in accordance with the present invention has a predominant low-frequency pole and a pair of complex poles conjugated with high frequency in a position practically the same as those of the above mentioned known circuit.

There is also a zero to the left but it is at lower frequency than that of the known circuit so that it helps improve the phase margin more significantly.

It should however be noted that the zero to the right is at a much higher frequency than that of the known circuit and therefore the shift-down in the phase margin introduced thereby is almost negligible. The result is a stability for equal load and dimensions of the transistors much better than that of the above mentioned known circuit and the improvement in terms of phase margin can be on the order of 30 degrees or more.

As an alternative and keeping the same stability the OTA band can be broadened to obtain a circuit much faster than the above without increasing the integration area and operating current.

In the known circuit the zero to the right is determined by the capacitance CC which constitutes a path parallel to that of the signal and at the frequency of the zero takes from the output node the same current injected from the signal path and cancelling de facto the output signal. In a circuit in accordance with the present invention said parallel path is given by the Cgd of the transistor M8 which, being much smaller than CC, gives a zero to the right with much higher frequency.

The reason the zero to the left is at lower frequency is that in determining this zero CC is involved while previously the Cgd of the transistor M8 took its place. The capacitance CC has a higher value and lowers the frequency of the zero to the left, further improving the phase margin.

The only capacitance on which depends the zero to the right is Cgd8 which is a small parasite capacitance. This zero therefore has very high frequency. In the above mentioned circuit it also depended on the compensation capacitance CC which had a higher a value. Therefore this zero has lower frequency and considerably worsens amplifier stability.

A differential transconductance amplifier in accordance with the present invention can also operate at low supply levels with high rejection of disturbances on the supplies. This circuit can be provided in a CMOS process. The principal advantage of the present invention consists of an intrinsically greater stability thanks to the zero-pole position of the transfer function compared to the solutions of the known art. Or the advantage consists of a greater gain-band product for given phase margin and load values and for comparable transistor sizes.

It is clear that modification, integration and replacement of elements can be made to the embodiment described above by way of nonlimiting example without thereby going beyond the protective scope of the following claims.

A circuit in accordance with the present invention can be provided with a PMOS input as shown in FIG. 2 or in the dual configuration with NMOS input in a manner known to those skilled in the art.

## Claims

1. Operational transconductance amplifier comprising a differential input stage (M1,M2) inserted between two terminals (+VCC,-VCC) of a supply voltage generator in series with a first (M3,M5) and a second cascode stage (M4,M6) connected to first and second connection nodes, respectively, of the differential input stage and a differential output stage in which a first transistor (M8A) and a second transistor (M8B) are inserted with a first and a second terminal respectively each in series with a first (M7A) and a second current generator (M7B) respectively between the two supply voltage generator terminals and characterised in that the first terminal of the first transistor (M8A) and the first terminal of the second transistor (M8B), which are output terminals of the amplifier (VOUT+,VOUT-) are coupled with an intermediate node (C) of the first cascode stage (M3,M5) and an intermediate node (D) of the second cascode stage (M4,M6) respectively through a first and a second condenser (CCA,CCB) and in that the first connection node (A) between the input stage and the first cascode stage and the second connection node (B) between the input stage and the second cascode stage are directly connected to a command terminal of the first transistor (M8A) and a command terminal of the second transistor (M8B) respectively.

2. Operational amplifier in accordance with claim 1 characterised in that the differential input stage comprises a pair of transistors (M1,M2) having first terminals connected to the first and second cascode stages respectively, second terminals connected to a first terminal (+VCC) of the supply voltage generator through a current generator (MO) and command terminals which are input terminals of the amplifier (VIN-,VIN+).

3. Operational amplifier in accordance with claim 2 characterised in that each cascode stage comprises a pair of transistors (M3,M5) and (M4,M6) inserted in series between them with first and second terminals between the differential input stage and a second terminal of the supply voltage generator and having command terminals connected to polarisation circuitry means and the connection nodes between the transistors of each pair being said intermediate nodes (C,D) of the first and second cascode stage.

4. Operational amplifier in accordance with claim 2 characterised in that the current generators are transistors (M7A,M7B).

5. Operational amplifier in accordance with claim 4 characterised in that the transistors of the differential input stage and of the current generators have a first type of conductivity and the transistors of the cascode stages and said first and second transistors have a second type of conductivity opposite that of the first.

6. Operational amplifier in accordance with claim 5 characterised in that it is integrated with CMOS technology.

## Patentansprüche

1. Transkonduktanz-Operationsverstärker, umfassend eine Differenzeingangsstufe (M1, M2), zwischen zwei Anschlüssen (+VCC,-VCC), einer Versorgungsspannungsquelle eingefügt in Serie mit einer ersten (M3, M5) und einer zweiten Kaskodestufe (M4, M6), die an einen ersten bzw. einen zweiten Verbindungsknoten der Differenzeingangsstufe und einer Differenzausgangsstufe angeschlossen sind, in der ein erster Transistor (M8A) und ein zweiter Transistor (M8B) mit einem ersten und einem zweiten Anschluß in Reihe mit einer ersten (M7A) bzw. einer zweiten Stromquelle (M7B) zwischen die zwei Anschlüsse der Versorgungsspannungsquelle gekoppelt sind, dadurch gekennzeichnet, daß der erste Anschluß des ersten Transistors (M8A) und der erste Anschluß des zweiten Transistors (M8B), die Ausgangsanschlüsse des Verstärkers (VOUT+, VOUT-) bilden, mit einem Zwischenknoten (C) der ersten Kaskodestufe (M3, M5) bzw. einem Zwischenknoten (D) der zweiten Kaskodestufe (M4, M6) über einen ersten bzw. einen zweiten Kondensator (CCA, CCB) gekoppelt sind, und daß der erste Verbindungsknoten (A) zwischen der Eingangsstufe und der ersten Kaskodestufe und der zweite Verbindungsknoten (B) zwischen der Eingangsstufe und der zweiten Kaskodestufe direkt an einen Steueranschluß des ersten Transistors (M8A) bzw. einen Steueranschluß des zweiten Transistors (M8B) angeschlossen sind.

2. Operationsverstärker nach Anspruch 1, dadurch gekennzeichnet, daß die Differenzeingangsstufe ein Paar Transistoren (M1, M2) enthält, die mit ersten Anschlüssen an die erste bzw. die zweite Kaskodestufe angeschlossen sind, die mit zweiten Anschlüssen an einen ersten Anschluß (+VCC) der Versorungsspannungsquelle über eine Stromquelle (M0) angeschlossen sind, und deren Steueranschlüsse die Eingangsanschlüsse des Verstärkers (VIN-, VIN+) bilden.

3. Operationsverstärker nach Anspruch 2, dadurch gekennzeichnet, daß jede Kaskodestufe ein Paar Transistoren (M3, M5; M4, M6) enthält, mit einem ersten und einem zweiten Anschluß jeweils eingefügt zwischen die Differenzeingangsstufe und einen zweiten Anschluß der Versorgungsspannungsquelle, wobei ihre Steueranschlüsse an eine Polarisationsschaltungseinrichtung angeschlossen sind und die Verbindungsknoten zwischen den Transistoren jedes Paares die Zwischenknoten (C, D) der ersten und der zweiten Kaskodestufe bilden.

4. Operationsverstärker nach Anspruch 2, dadurch gekennzeichnet, daß die Stromquellen Transistoren (M7A, M7B) sind.

5. Operationsverstärker nach Anspruch 4, dadurch gekennzeichnet, daß die Transistoren der Differenzeingangsstufe und die Stromquellen einem ersten Leitungstyp entsprechen und die Transistoren der Kaskodestufen sowie der erste und der zweite Transistor einem zweiten Leitungstyp, der dem ersten Leitungstyp entgegengesetzt ist, entsprechen.

6. Operationsverstärker nach Anspruch 5, dadurch gekennzeichnet, daß er in CMOS-Technologie integriert ist.

## Revendications

1. Amplificateur opérationnel de transconductance comportant un étage d'entrée différentielle (M1,M2) inséré entre deux bornes (+VCC,-VCC) d'un générateur de tension d'alimentation en série avec des premier (M3,M5) et second (M4,M6) étages cascode connectés respectivement à des premier et second noeuds de connexion de l'étage d'entrée différentielle et un étage de sortie différentielle dans lequel un premier transistor (M8A) et un second transistor (M8B) sont insérés chacun respectivement avec des première et seconde bornes en série avec des premier (M7A) et second (M7B) générateurs de courant respectivement entre les deux bornes du générateur de tension d'alimentation et caractérisé en ce que la première borne du premier transistor (M8A) et la première borne du second transistor (M8B), qui sont des bornes de sortie de l'amplificateur (VOUT+,VOUT-), sont couplées à un noeud intermédiaire (C) du premier étage cascode (M3,M5) et à un noeud intermédiaire (D) du second étage cascode (M4,M6) respectivement par l'intermédiaire de premier et second condensateurs (CCA,CCB) et en ce que le premier noeud de connexion (A) entre l'étage d'entrée et le premier étage cascode et le second noeud (B) entre l'étage d'entrée et le second étage cascode sont directement connectés à une borne de commande du premier transistor (M8A) et à une borne de commande du second transistor (M8B) respectivement.

2. Amplificateur opérationnel selon la revendication 1, caractérisé en ce que l'étage d'entrée différentielle comporte une paire de transistors (M1,M2) ayant des premières bornes connectées respectivement aux premier et second étages cascode, des secondes bornes connectées à la première borne (+VCC) du générateur de tension d'alimentation par l'intermédiaire d'un générateur de courant (MO) et des bornes de commande qui sont des bornes d'entrée de l'amplificateur (VIN-, VIN+).

3. Amplificateur opérationnel selon la revendication 2, caractérisé en ce que chaque étage cascode comprend une paire de transistors (M3,M5) et (M4,M6) insérés en série entre eux avec des première et seconde bornes entre l'étage d'entrée différentielle et une seconde borne du générateur de tension d'alimentation et présentant des bornes de commande connectées à des moyens de circuit de polarisation et les noeuds de connexion entre les transistors de chaque paire étant des noeuds intermédiaires (C,D) des premier et second étages cascode.

4. Amplificateur opérationnel selon la revendication 2, caractérisé en ce que les générateurs de courant sont des transistors (M7A,M7B).

5. Amplificateur opérationnel selon la revendication 4, caractérisé en ce que les transistors de l'étage d'entrée différentielle et des générateurs de courant présentent un premier type de conductivité et les transistors des étages cascode et lesdits premier et second transistors présentent un second type de conductivité opposé au premier.

6. Amplificateur opérationnel selon la revendication 5, caractérisé en ce qu'il est intégré avec une technologie CMOS.
